# EUROPEAN PATENT APPLICATION

(11) **EP 2 463 918 A1**
(43) Date of publication of application: **13.06.2012**
(21) Application number: 10806482.5
(22) Date of filing: 04.08.2010
(51) Int. Cl.: H01L 31/042

(54) **SOLAR CELL MODULE**

(30) Priority: 07.08.2009 JP 2009185040
(71) Applicant: Sharp Kabushiki Kaisha, Osaka-shi, Osaka 545-8522 (JP)
(72) Inventor: SHIMIZU, Akira, Osaka 545-8522 (JP)
(74) Representative: Müller - Hoffmann & Partner
(86) International application number: PCT/JP2010/063176
(87) International publication number: WO 2011/016483

(57) **Abstract**

With a solar cell module (1A) according to one embodiment, a plurality of solar cells (3) are formed in rows and disposed in parallel on an insulating substrate (2), and are connected in series. The proximal ends of lead wires (7) are connected to end electrodes (6) provided at both ends of the serial connection. These lead wires (7) are guided from the end electrodes (6) along the insulating substrate (2), and are formed in a curved shape. The shape of the lead wires (7) may also be that of a mesh formed from fine copper or aluminum wire.

## Description

### Technical Field

The present invention relates to a solar cell module in which lead wires are drawn out from end electrodes provided to both ends of a plurality of solar cells that are formed on an insulating substrate and connected in series.

### Background Art

A so-called thin-film solar cell, which is a type of solar cell that has a structure in which a thin layer of silicon is deposited on a light-transmitting insulating substrate, such as a glass substrate, requires the use of far less silicon than a crystalline solar cell, and the production process is also simpler, so the cost is lower, and because of this such solar cells have been in the spotlight of late.

Various solar cell modules having the above-mentioned type of structure have been thought up, and various proposals have been made for structural designs in these solar cell modules (see, for example, Patent Document 1).

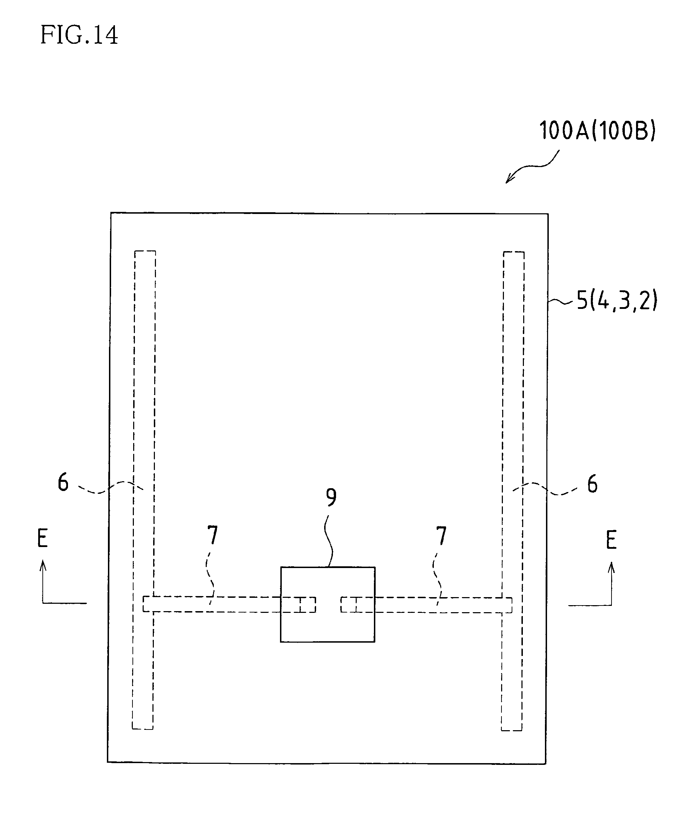

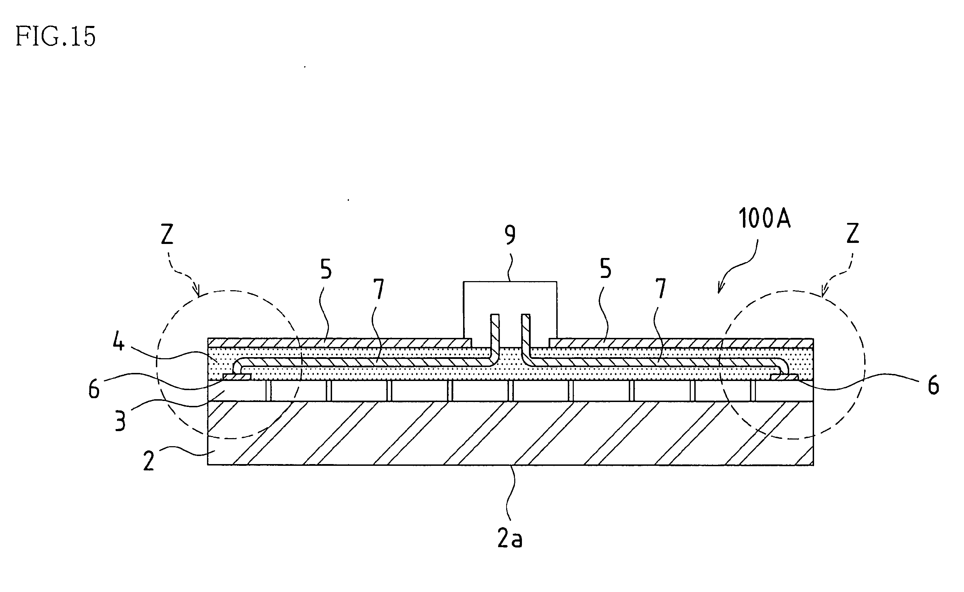

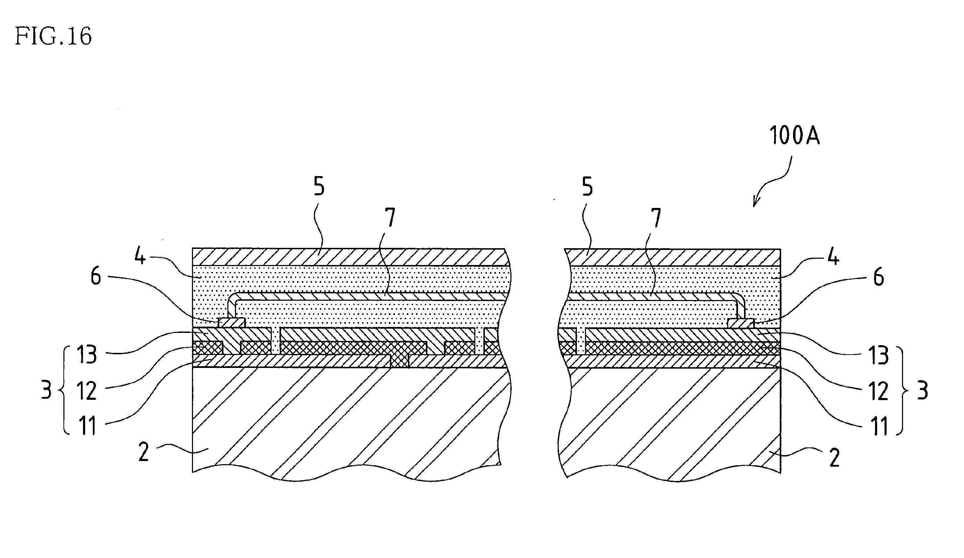

One example of the above-mentioned type of solar cell module is a solar cell module 100A having the structure shown in FIGS. 14 to 16. FIG. 14 is a plan view of the solar cell module 100A as seen from the rear. FIG. 15 is a cross section along the E-E line in FIG. 14. FIG. 16 is a detailed enlargement of the Z portion in FIG. 15. In the drawings discussed in this specification, the solar cell module is displayed with the front and back reversed upside-down from the normal display. That is, the top in the drawings is the back side of the solar cell module, and the bottom is the front side.

In FIGS. 14 to 16, the above-mentioned solar cell module 100A is configured such that a plurality of serially connected solar cells 3 are formed on a glass substrate 2 (a light-transmitting insulating substrate), a resin filling layer 4 is formed on these solar cells 3, and a back sheet layer 5 is formed over the resin filling layer 4.

With the above-mentioned solar cell module 100A, as shown in FIG. 16, each of the solar cells 3 has a transparent conductive film layer 11, an amorphous semiconductor layer 12 made from silicon, and a rear metal layer 13 laminated in that order, in three layers, in rows, in the lengthwise direction of the solar cell module 100A, on the glass substrate 2.

The solar cells 3 that are each made up of these three layers (the transparent conductive film layer 11, the amorphous semiconductor layer 12, and the rear metal layer 13) are connected in series to each other as discussed above to form the solar cell module 100A.

Specifically, in FIG. 16, the rear metal layer 13 of the solar cell 3 at the left end is connected to the transparent conductive film layer 11 of the adjacent solar cell 3 on the right side (which is adjacent to the left-end solar cell 3), and similarly, the rear metal layer 13 of the right-side adjacent solar cell 3 is connected to the transparent conductive film layer 11 of the adjacent solar cell 3 on its right side (which is adjacent to the right-side adjacent solar cell 3), and so on with the solar cells 3 being connected in series.

In FIGS. 14 and 15, end electrodes 6 are formed in the lengthwise direction of the solar cell module 100A on the rear metal layer 13 of the left-end solar cell 3 connected to the transparent conductive film layer 11 of the adjacent solar cell 3 on the right side which is adjacent to the left-end solar cell 3, and on the rear metal layer 13 of the solar cell 3 at the right end.

The proximal ends of lead wires 7, which are made of copper or aluminum foil, for example, are connected one each to these end electrodes 6. These lead wires 7 are drawn out in a straight line from the end electrodes 6, along the glass substrate 2 through the resin filling layer 4, and toward the center of the solar cell module 100A. These lead wires 7 curve in the back side direction of the glass substrate 2 at the center of the solar cell module 100A, that is, upward in FIG. 15, and their distal ends protrude upward from the resin filling layer 4 and are accommodated in a terminal box 9. In the drawings referred to above, the shape inside the terminal box 9 is partially omitted.

The draw-out structure of the above-mentioned lead wires 7 is substantially the same as that in the cell module discussed in Patent Document 1 (see FIG. 6 in Patent Document 1). Specifically, the lead wires are drawn out in a straight line from the end electrodes, along the glass substrate, and toward the center of the cell module.

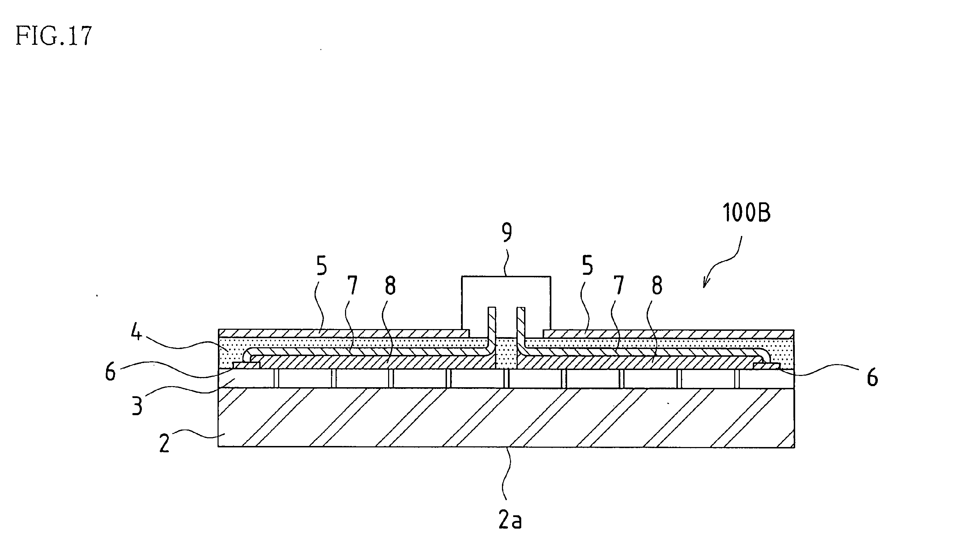

There is another solar cell module 100B that is constituted the same as the above-mentioned solar cell module 100A. With this solar cell module 100B, as shown in FIG. 17, the lead wires 7 are bonded with an adhesive agent to the back of the solar cells 3.

Again with this solar cell module 100B, the lead wires 7 are drawn out in a straight line from end electrodes 6, along a glass substrate 2 through a resin filling layer 4, and toward the center of the solar cell module 100B.

### Prior Art Document

### Patent Document

Patent Document 1: JP H9-326497A

### Summary of Invention

### Problem to be Solved by the Invention

However, the above-mentioned solar cell modules, in which a plurality of solar cells comprising an amorphous semiconductor layer are connected in series and formed on a glass substrate that is a light-transmitting insulating substrate, are usually installed and used outdoors. Therefore, there is the risk of encountering the following problems under environments exposed to wind and rain or to temperature differentials.

Specifically, as discussed above, with the solar cell module 100A or the solar cell module 100B, or with a conventional solar cell module such as that discussed in Patent Document 1, the lead wires are drawn out in a straight line from the end electrodes, along the glass substrate, toward the center of the solar cell module.

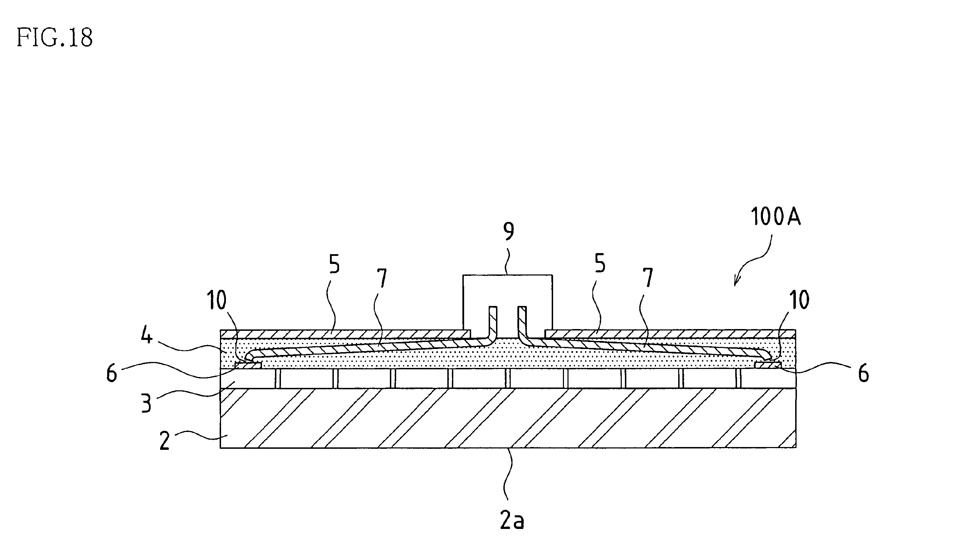

Accordingly, when, for example, the above-mentioned solar cell module 100A is exposed to low temperatures, the difference in the coefficients of thermal expansion between the glass substrate 2 and the lead wires 7 causes the lead wires 7 to shrink, placing stress on the proximal ends of the lead wires 7 connected to the end electrodes 6. As shown in FIG. 18, this can cause the lead wires 7 to break at their proximal ends, creating breaks 10, or the end electrodes 6 may separate from the rear metal layer 13 of the solar cell 3.

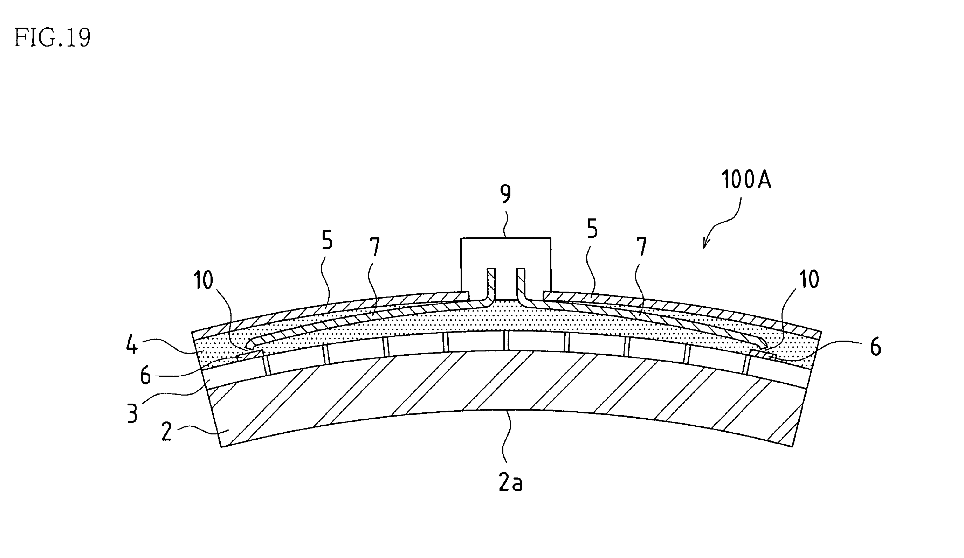

Also, if the surface of the above-mentioned solar cell module 100A, and more specifically, the glass substrate surface 2a of the solar cell module 100A, should be buffeted by a strong wind to the point that it bends and deforms so that it sticks out on the back side, the lead wires 7 will be pulled, which places stress on the proximal ends of the lead wires 7 connected to the end electrodes 6. Accordingly, as shown in FIG. 19, there is the risk that the lead wires 7 will break at their proximal ends and create breaks 10, or that the end electrodes 6 will separate from the rear metal layer 13 of the solar cell 3.

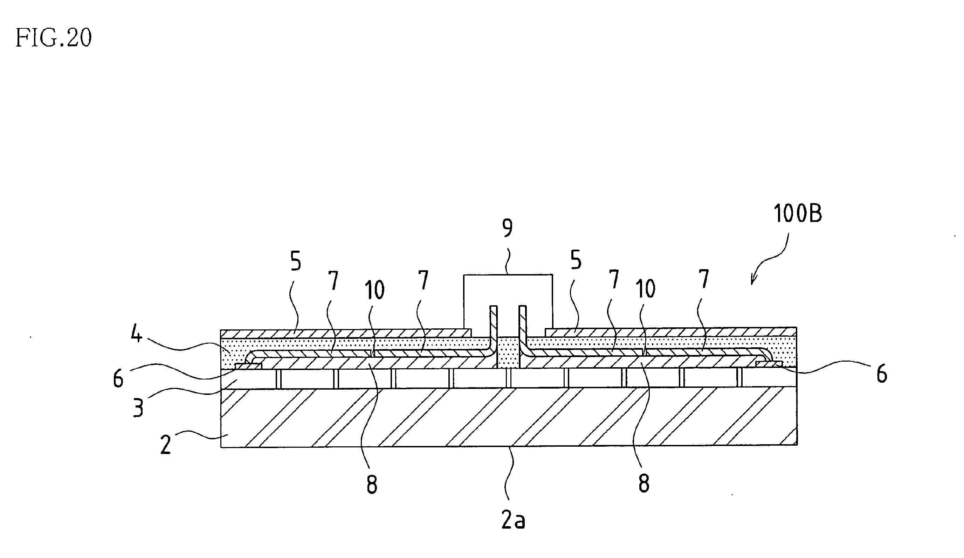

Also, if, for example, the above-mentioned solar cell module 100B is exposed to low temperatures, for example, the difference in the coefficients of thermal expansion between the glass substrate 2 and the lead wires 7 causes the lead wires 7 to shrink, placing stress on the lead wires 7 that are bonded with an adhesive agent to back of the solar cell 3. Accordingly, as shown in FIG. 20, this can cause the lead wires 7 to break in the middle and create breaks 10, or cause the solar cell 3 to separate from the glass substrate 2.

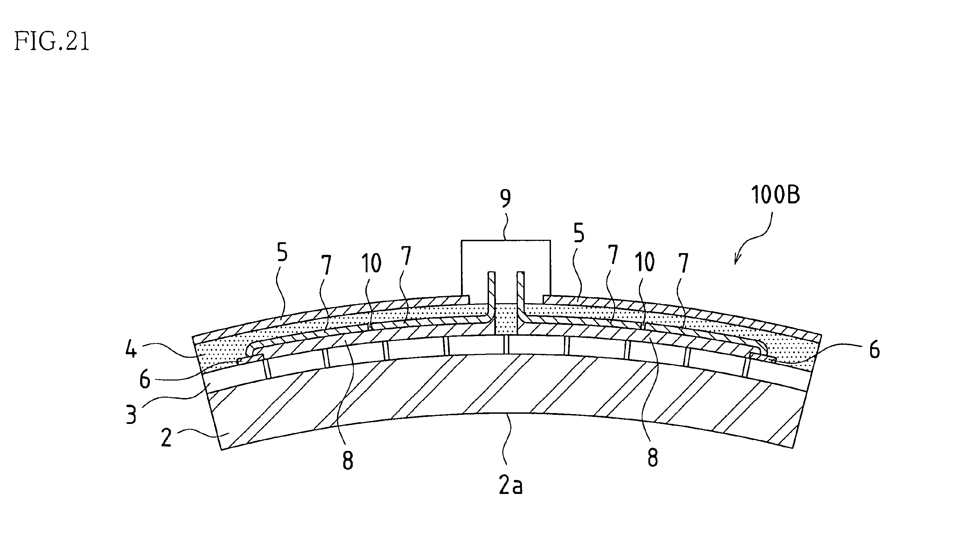

Also, if, for example, the surface of the above-mentioned solar cell module 100B, and more specifically, the glass substrate surface 2a of the solar cell module 100B, should be buffeted by a strong wind to the point that it bends and deforms so that it sticks out on the back side, the lead wires 7 will be pulled, which places stress on the proximal ends of the lead wires 7 bonded with an adhesive agent to the back of the solar cell 3. Accordingly, as shown in FIG. 21, there is the risk that the lead wires 7 will break in the middle and create breaks 10, or that the solar cell 3 will separate from the glass substrate 2.

The present invention provides a solar cell module in which solar cells are connected in series on a glass substrate that is a light-transmitting insulating substrate, wherein breakage of the lead wires of the solar cell module and other such problems can be prevented even under environments exposed to wind and rain or to temperature differentials.

### Means for Solving the Problems

The solar cell module of the present invention includes an insulating substrate, a plurality of solar cells that are formed in rows and disposed in parallel on the insulating substrate, extraction electrodes that are provided intermediate or at both ends of the serial connection, and lead wires that are connected at their proximal ends to the extraction electrodes, and are drawn out from the extraction electrodes along the insulating substrate, wherein the lead wires are formed in a mesh shape.

Accordingly, when the above-mentioned solar cell module is exposed to low temperatures, problems related to the lead wires can be prevented as discussed below.

Specifically, even if a difference in the coefficients of thermal expansion between the insulating substrate and the lead wires should cause the lead wires to shrink, placing stress on the proximal ends of the lead wires connected to the extraction electrodes, these lead wires are stretchable because they are formed in a curved shape as mentioned above, and this prevents the lead wires from breaking at their proximal ends, or the extraction electrodes from separating.

Also, if the surface of the above-mentioned solar cell module should be buffeted by a strong wind to the point that it bends and deforms so as to stick out on the back side, problems related to the lead wires can be prevented as follows, just as discussed above.

Specifically, even if deformation of the solar cell module tugs on the lead wires and places stress on the proximal ends of the lead wires connected to the extraction electrodes, these lead wires are stretchable because they are formed in a curved shape as mentioned above, and this prevents the lead wires from breaking at their proximal ends, or the extraction electrodes from separating.

Also, even if the lead wires of the above-mentioned solar cell module are bonded with an adhesive agent to the solar cells as discussed below, and if the above-mentioned solar cell module is then exposed to low temperatures, problems related to the lead wires can be prevented as discussed below.

Specifically, even if a difference in the coefficients of thermal expansion between the insulating substrate and the lead wires should cause the lead wires to shrink, placing stress on the lead wires bonded with an adhesive agent on the solar cells, these lead wires are stretchable because they are formed in a curved shape as mentioned above, and this prevents the lead wires from breaking in the middle, or the solar cells from separating from the insulating substrate.

Also, if the surface of the above-mentioned solar cell module in which the lead wires are bonded with an adhesive agent on the solar cells should be buffeted by a strong wind to the point that it bends and deforms so as to stick out on the back side, problems related to the lead wires can be prevented as follows, just as discussed above.

Specifically, even if deformation of the solar cell module tugs on the lead wires and places stress on the lead wires bonded with an adhesive agent to the back of the solar cells, these lead wires are stretchable because they are formed in a curved shape as mentioned above, and this prevents the lead wires from breaking in the middle, or the solar cells from separating from the insulating substrate.

With the above-mentioned solar cell module, the curving of the lead wires may be such that they curve in the approximate thickness direction of the insulating substrate. Alternatively, they may curve in a direction that is approximately parallel to the insulating substrate.

Alternatively, the solar cell module of the present invention may include an insulating substrate, a plurality of solar cells that are formed in rows and disposed in parallel on the insulating substrate, and that are connected in series, extraction electrode that are provided intermediate or at both ends of the serial connection, and lead wires that are connected at their proximal ends to the extraction electrodes, and are drawn out from the extraction electrodes along the insulating substrate, wherein the lead wires are formed in a mesh shape consisting of a mesh of fine metal wires.

With the solar cell module formed in this way, the lead wires formed in a mesh shape are stretchable as are the above-mentioned lead wires formed in a curved shape, so the same operation and effect are obtained as with the above-mentioned solar cell module in which the lead wires are formed in a curved shape.

Also, with the above-mentioned solar cell module, a resin filling layer may be formed on the solar cells, and the above-mentioned lead wires embedded in this resin filling layer. Alternatively, the lead wires embedded in this resin filling layer may be bonded on the solar cells. Doing this affords a stronger structure of the solar cell module.

### Effects of the Invention

With the present invention, the lead wires of the solar cell module are formed in a curved shape. Accordingly, if the solar cell module is exposed to low temperatures, the problems related to the lead wires can be prevented as discussed below. Specifically, even if a difference in the coefficients of thermal expansion between the insulating substrate and the lead wires should cause the lead wires to shrink, placing stress on the proximal ends of the lead wires connected to the extraction electrodes, these lead wires are stretchable because they are formed in a curved shape as mentioned above, and this prevents the lead wires from breaking at their proximal ends, or the extraction electrodes from separating.

Also, if the surface of the above-mentioned solar cell module should be buffeted by a strong wind to the point that it bends and deforms so as to stick out on the back side, problems related to the lead wires can be prevented as follows, just as discussed above. Specifically, even if deformation of the solar cell module tugs on the lead wires and places stress on the proximal ends of the lead wires connected to the extraction electrodes, these lead wires are stretchable because they are formed in a curved shape as mentioned above, and this prevents the lead wires from breaking at their proximal ends, or the extraction electrodes from separating.

Also, even if the lead wires of the above-mentioned solar cell module are bonded with an adhesive agent to the solar cells, and if the above-mentioned solar cell module is then exposed to low temperatures, problems related to the lead wires can be prevented as discussed below. Specifically, even if a difference in the coefficients of thermal expansion between the insulating substrate and the lead wires should cause the lead wires to shrink, placing stress on the lead wires bonded with an adhesive agent on the solar cells, these lead wires are stretchable because they are formed in a curved shape as mentioned above, and this prevents the lead wires from breaking in the middle, or the solar cells from separating from the insulating substrate.

Also, if the surface of the above-mentioned solar cell module in which the lead wires are bonded with an adhesive agent on the solar cells should be buffeted by a strong wind to the point that it bends and deforms so as to stick out on the back side, problems related to the lead wires can be prevented as follows, just as discussed above. Specifically, even if deformation of the solar cell module tugs on the lead wires and places stress on the lead wires bonded with an adhesive agent to the back of the solar cells, these lead wires are stretchable because they are formed in a curved shape as mentioned above, and this prevents the lead wires from breaking in the middle, or the solar cells from separating from the insulating substrate.

### Brief Description of Drawings

[FIG. 1] FIG. 1 is a plan view of a solar cell module according to a first embodiment as seen from the back side.
[FIG. 2] FIG. 2 is a cross section along the A-A line in FIG. 1.
[FIG. 3] FIG. 3 is a detailed enlargement of the X portion in FIG. 2.
[FIG. 4] FIGS. 4(a) to 4(d) are cross sections of examples of lead wires formed in a curved shape in the thickness direction of the glass substrate of the solar cell module according to the first embodiment.
[FIG. 5] FIGS. 5(a) and 5(b) are plan views of examples of lead wires formed in a curved shape in a direction that is approximately parallel to the glass substrate of the solar cell module according to the first embodiment.
[FIG. 6] FIGS. 6(a) to 6(c) are partial plan views of examples of lead wires with other shapes in the solar cell module in the first embodiment.
[FIG. 7] FIG. 7 is a cross section of another solar cell module according to the first embodiment.
[FIG. 8] FIG. 8 is a plan view of a solar cell module according to a second embodiment as seen from the back side.
[FIG. 9] FIG. 9 is a cross section along the C-C line in FIG. 8.
[FIG. 10] FIG. 10 is a cross section along the B-B line in FIG. 8.
[FIG. 11] FIG. 11 is a cross section along the D-D line in FIG. 8.
[FIG. 12] FIG. 12 is a detailed enlargement of the Y1 portion in FIG. 9.
[FIG. 13] FIG. 13 is a detailed enlargement of the Y2 portion in FIG. 10.
[FIG. 14] FIG. 14 is a plan view of an example of a conventional solar cell module as seen from the back side.
[FIG. 15] FIG. 15 is a cross section along the E-E line in FIG. 14.
[FIG. 16] FIG. 16 is a detailed enlargement of the Z portion in FIG. 15.
[FIG. 17] FIG. 17 is a cross section of another example of a conventional solar cell module.
[FIG. 18] FIG. 18 is a cross section of a conventional solar cell module in which a problem has occurred (part 1).
[FIG. 19] FIG. 19 is a cross section of the conventional solar cell module in which a problem has occurred (part 2).
[FIG. 20] FIG. 20 is a cross section (part 1) of another conventional solar cell module in which a problem has occurred (part 1).
[FIG. 21] FIG. 21 is a cross section of the conventional solar cell module in which a problem has occurred (part 2).

### Description of Embodiments

Next, the solar cell module according to embodiments of the present invention will be described in detail through reference to the drawings. First, a solar cell module 1A and a solar cell module 1B according to a first embodiment will be described, and then a solar cell module 1C according to a second embodiment will be described.

### First Embodiment

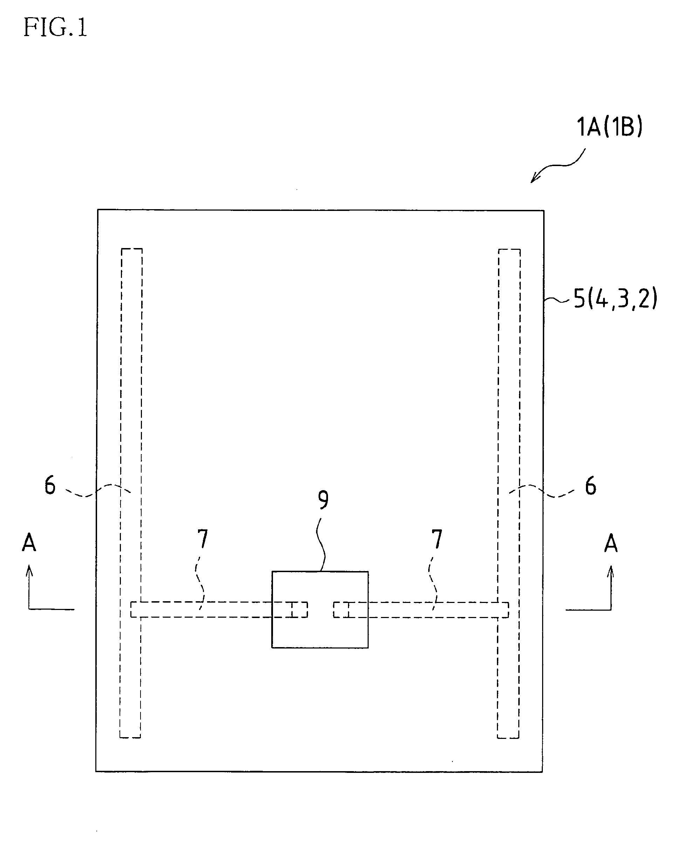

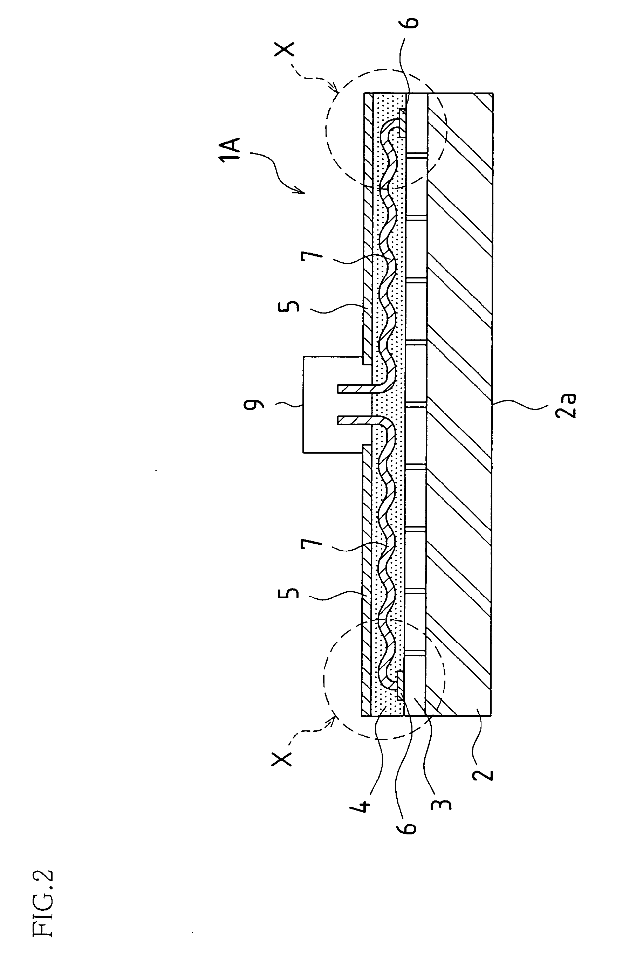

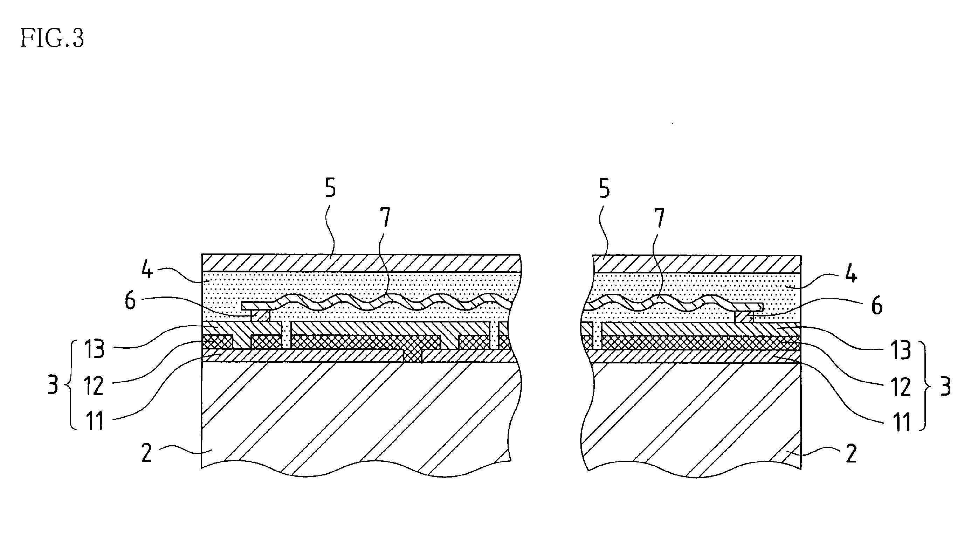

FIG. 1 is a plan view of a solar cell module according to a first embodiment as seen from the back side. FIG. 2 is a cross section along the A-A line in FIG. 1. FIG. 3 is a detailed enlargement of the X portion in FIG. 2. As discussed above, in the drawings in this specification, the solar cell module is shown with the front and back upside-down as compared to a normal display. That is, the top in the drawings is the back side of the solar cell module, and the bottom is the front side.

The solar cell module 1A according to the first embodiment has substantially the same structure as the solar cell module 100A in the conventional example given above. That is, in FIGS. 1 to 3, the solar cell module 1A is constituted such that a plurality of solar cells 3 that are connected in series are formed on a glass substrate 2 that is a light-transmitting insulating substrate, a resin filling layer 4 is formed on these solar cells 3, and a back sheet layer 5 is formed over the resin filling layer 4.

The above-mentioned solar cell module 1A is similar to the conventional solar cell module 100A in that, as shown in FIG. 3, the solar cells 3 each have a transparent conductive film layer 11, an amorphous semiconductor layer 12 made from silicon, and a rear metal layer 13 laminated in that order, in three layers, in rows, in the lengthwise direction of the solar cell module 1A, on the glass substrate 2.

The solar cells 3 that are each made up of these three layers (the transparent conductive film layer 11, the amorphous semiconductor layer 12, and the rear metal layer 13) are connected in series to each other as discussed above to form the solar cell module 1A.

Specifically, in FIG. 3, the rear metal layer 13 of the solar cell 3 at the left end is connected to the transparent conductive film layer 11 of the adjacent solar cell 3 on the right side (which is adjacent to the left-end solar cell 3), and similarly, the rear metal layer 13 of the right-side adjacent solar cell 3 is connected to the transparent conductive film layer 11 of the adjacent solar cell 3 on its right side (which is adjacent to the right-side adjacent solar cell 3), and so on with the solar cells 3 being connected in series.

In FIGS. 1 to 3, end electrodes 6 are formed in the lengthwise direction of the solar cell module 1A on the rear metal layer 13 of the left-end solar cell 3 connected to the transparent conductive film layer 11 of the adjacent solar cell 3 on the right side which is adjacent to the left-end solar cell 3, and on the rear metal layer 13 of the solar cell 3 at the right end. These end electrodes 6 correspond to the extraction electrodes mentioned above.

The proximal ends of lead wires 7, which are made of copper or aluminum foil, for example, are connected one each to these end electrodes 6. These lead wires 7 are drawn out from the end electrodes 6, along the glass substrate 2 through the resin filling layer 4, and toward the center of the cell module 1A.

These lead wires 7 curve in the back side direction of the glass substrate 2 at the center of the cell module 1A (that is, they bend upward in FIG. 15, so the back side direction of the glass substrate 2 will hereinafter be called "upward," and the front side direction of the glass substrate 2 will be called "downward"), and their distal ends protrude upward from the resin filling layer 4 and are accommodated in a terminal box 9. In the drawings referred to above, the shape inside the terminal box 9 is partially omitted.

The solar cell module 1A of the first embodiment differs from the conventional solar cell module 100A discussed above in the following respect. With the solar cell module 100A, in FIGS. 15 and 16, the lead wires 7 that are drawn out from the end electrodes 6, along the glass substrate 2 through the resin filling layer 4, and toward the center of the cell module 100A are straight.

In contrast, with the solar cell module 1A of the first embodiment, as shown in FIGS. 2 and 3, the lead wires 7 that are drawn out from the end electrodes 6, along the glass substrate 2 through the resin filling layer 4, and toward the center of the cell module 1A are formed with continuous undulatations so that they curve in the thickness direction of the glass substrate 2 (that is, in FIG. 2, they are curved in the up-and-down direction, and the thickness direction of the glass substrate 2 will hereinafter be referred to simply as the up-and-down direction).

Accordingly, the solar cell module 1A of the above-mentioned first embodiment has the following operation and effect. When this solar cell module is exposed to low temperatures, problems related to the lead wires 7 can be prevented as follows.

That is, with the solar cell module 1A, even if a difference in the coefficients of thermal expansion between the glass substrate 2 and the lead wires 7 in the solar cell module 1A causes the lead wires 7 to shrink, and this places stress on the proximal ends of the lead wires 7 connected to the end electrodes 6, the lead wires 7 are stretchable because they are formed in a curved shape as discussed above, which prevents the lead wires 7 from breaking at their proximal ends, or the end electrodes 6 from separating from the rear metal layer 13 of the solar cells 3.

Also, if the surface of the above-mentioned solar cell module 1A, and more specifically, the glass substrate surface 2a of the solar cell module 1A, should be buffeted by a strong wind to the point that it bends and deforms so that it sticks out on the back side, the problems related to the lead wires 7 can be prevented in the same way as above.

Specifically, even if deformation of the solar cell module 1A tugs on the lead wires 7 and places stress on the proximal ends of the lead wires 7 connected to the end electrodes 6, these lead wires 7 are stretchable because they are formed in a curved shape as mentioned above, and this prevents the lead wires 7 from breaking at their proximal ends, or the end electrodes 6 from separating from the rear metal layer 13 of the solar cells 3.

With the solar cell module 1A of the first embodiment, as shown in FIG. 2, the lead wires 7 that are drawn out from the end electrodes 6, along the glass substrate 2 through the resin filling layer 4, and toward the center of the solar cell module 1A are formed in a shape that continuously undulates in the up-and-down direction from the end electrodes 6 all the way to the part that bends upward.

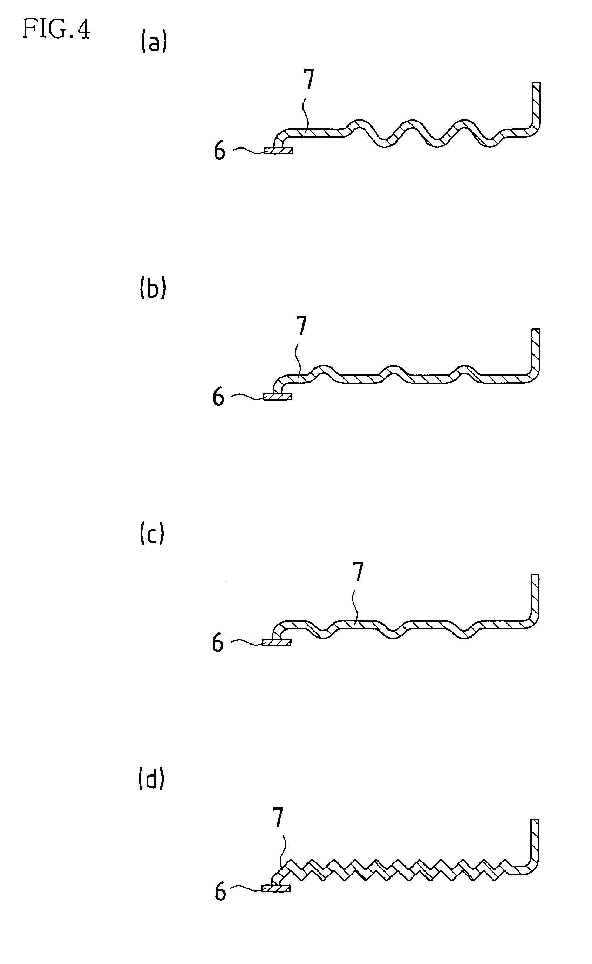

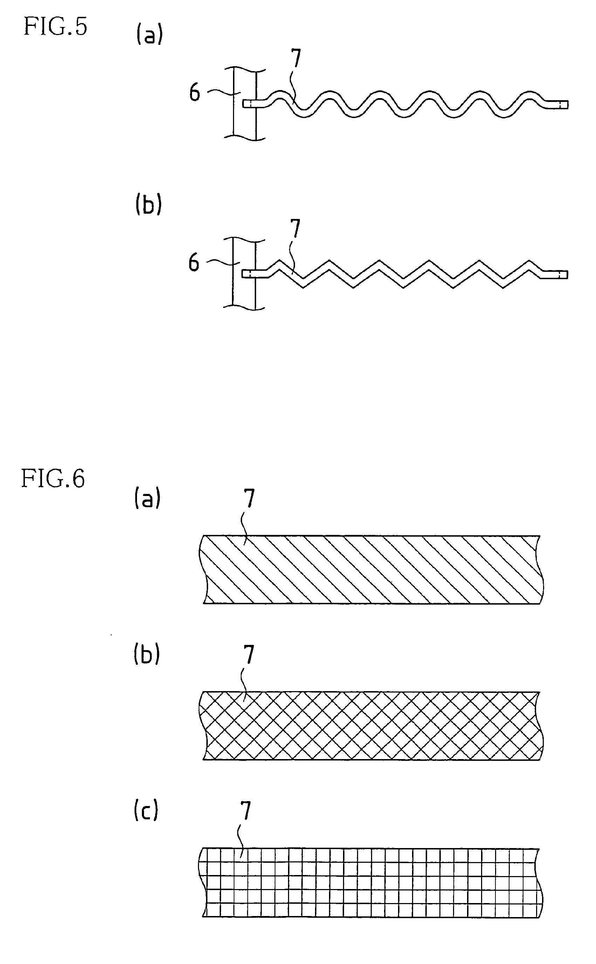

However, the curved shape of the lead wires 7 is not limited to this, and any shape may be used so long as it affords the lead wires 7 stretchability. FIGS. 4(a) to 4(d) and FIGS. 5(a) and 5(b) show other examples of the curved shape of the lead wires 7.

FIGS. 4(a) to 4(d) are cross sections of other examples of the lead wires 7 whose curved shape curves in the up-and-down direction, just as in the above description. In FIGS. 4(a) to 4(d), FIG. 4(a) is an example in which the shape of the lead wires 7 undulates in the up-and-down direction over part of the section going from the end electrodes 6 to the part that bends upward. Since this undulating shape curves up and down within the rear face sealing material of the module, the up and down height of the curved part is preferably less than or equal to the total thickness of the sealing material. For example, if a sealing material with a thickness of 0.4 mm is disposed above and below the lead wires, the up and down height of the undulations is preferably 0.8 mm or less. Also, this undulating portion does not have to be made over the entire length of the lead wires, and just the required amount of deformation may be used, taking into account mechanical deformation and deformation due to temperature. Specifically, if we let d1 be the amount of deformation due to temperature, d2 be the amount of mechanical deformation, L1 be the total length of the lead wires in their curved state, and L2 be the total length of the lead wires when they have been stretched out straight, the relation L2 > L1 + d1 + d2 should be satisfied. For example, as a working example of undulations, if copper lead wires that are 870 mm long and 0.08 mm thick are disposed on a glass substrate with a thickness of 4.0 mm, the amount of deformation due to temperature d1 is calculated by setting the lowest anticipated temperature and the temperature coefficient of glass and copper, which gives us d1 ≈ 1.3 mm, and the amount of mechanical deformation d2 is calculated by setting the anticipated radius of curvature of the glass, which gives us d2 ≈ 0.2 mm, and undulations are provided so as to satisfy a relation of L2 > L1 + d1 + d2 = 871.5 mm. As an example of the undulations in this case, if we assume that the undulation period is 2.0 mm, the undulation height in the up-and-down direction is 0.4 mm, and the external shape of the undulations is a sine curve, these conditions are satisfied if undulations are provided along a width of at least 18 mm of the 870 mm length of the lead wires. In actual practice, in a working example, the lead wires are stamped with undulations of 50 mm from a safety perspective.

FIG. 4(b) is an example in which upwardly convex undulations are formed non-continuously over the part of the lead wires 7 going from the end electrodes 6 to the portion that bends upward. FIG. 4(c) is an example in which downwardly convex undulations are formed non-continuously over the part of the lead wires 7 going from the end electrodes 6 to the portion that bends upward. The required undulation conditions are the same as in FIG. 4(a), and if, for example, 50 convex or concave shapes with a width of 1.0 mm and a height or depth of 0.2 mm are provided at a spacing of 15.0 mm, about the same amount of elongation as in the example in FIG. 4(a) can be dispersed over a wider range over the entire lead wires.

FIG. 4(d) is an example in which triangular undulations that are bent in the up-and-down direction are formed continuously over the part of the lead wires 7 going from the end electrodes 6 to the portion that bends upward. In this example of triangular undulations, the undulations may be formed as shown in FIGS. 4(a) to 4(c) above.

FIGS. 5(a) and 5(b) show plan views of examples of the lead wires 7 in which the curved shape curves in a direction that is substantially parallel to the glass substrate 2. FIG. 5(a) is an example in which undulations that curve in a direction substantially parallel to the glass substrate 2 are formed continuously over the part of the lead wires 7 going from the end electrodes 6 to the portion that bends upward. FIG. 5(b) is an example in which triangular undulations that are bent in a direction substantially parallel to the glass substrate 2 are formed continuously over the part of the lead wires 7 going from the end electrodes 6 to the portion that bends upward. These can be formed by a method in which they are cut out from a wide strip, or by a method in which flat copper wire is cut out. In this working example, cut-outs of 1.5 mm, alternating from left to right, were made in flat copper wire with a width of 6.0 mm to produce undulations and triangular undulations. These undulations may be formed as in FIGS. 4(a) to 4(c) above.

The curving of the lead wires 7 in the above example is formed simply so as to create a state of being parallel to a direction perpendicular to the lengthwise direction of the lead wires 7. However, in addition to the state discussed above, the curved state of the lead wires 7 may be as shown in FIG. 6(a), which is a state of being parallel to a direction that is inclined with respect to the lengthwise direction of the lead wires 7. Or, as shown in FIG. 6(b), it may be an X-shaped pattern with respect to the lengthwise direction of the lead wires 7, or a state of being crossed in a + shape as shown in FIG. 6(c). Alternatively, a plurality of conical or quadrilateral dots facing in the up-and-down direction may be formed on flat lead wires 7. When one of these shapes is used, a wide, thin strip of metal foil may be worked, such as stamping a copper foil with a width of 10.0 mm and a thickness of 0.05 mm.

The form of the lead wires may also be that of a mesh made of fine copper or aluminum wires. Lead wires formed in this mesh shape will be similar to the above-mentioned lead wires formed with a curved shape in that they will be stretchable, so a solar cell module equipped with lead wires formed in a mesh shape will have the same operation and effect as the above-mentioned solar cell module 1A equipped with lead wires formed in a curved shape.

Also, with the solar cell module 1A of the above first embodiment, as shown in FIG. 2, the lead wires 7 that are drawn out from the end electrodes 6 by curving in the up-and-down direction toward the center of the solar cell module 1A extend through the resin filling layer 4, and are embedded in the resin filling layer 4, but are not bonded onto the solar cells 3.

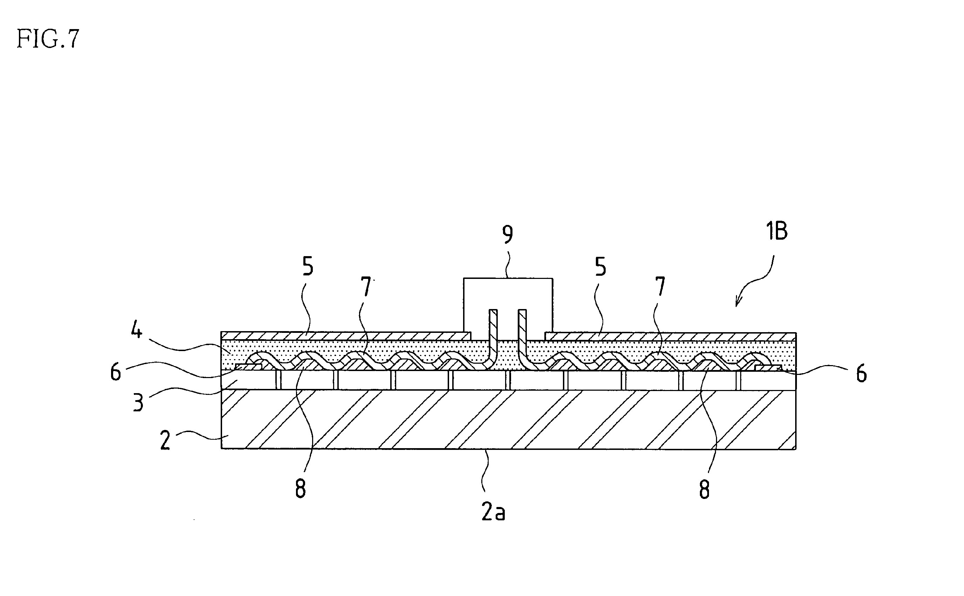

However, as shown in FIG. 7, lead wires 7 that are drawn out from the end electrodes 6 toward the center of a solar cell module 1B may be bonded onto the solar cells 3. This affords a stronger structure of the solar cell module.

The solar cell module 1B equipped with the lead wires 7 that are bonded with an adhesive agent 8 onto the solar cells 3 has the following operation and effect. Specifically, even if a difference in the coefficients of thermal expansion between the glass substrate 2 and the lead wires 7 should cause the lead wires 7 to shrink, placing stress on the lead wires 7 bonded with the adhesive agent 8 onto the solar cells 3, these lead wires 7 are stretchable because they are formed in a curved shape as mentioned above, and this prevents the lead wires 7 from breaking in the middle, or the solar cells 3 from separating from the glass substrate 2.

Also, with the above-mentioned solar cell module 1B in which the lead wires 7 are bonded with the adhesive agent 8 onto the solar cells 3, if the surface of the solar cell module 1B, that is, the glass substrate surface 2a of the solar cell module 1B, should be buffeted by a strong wind to the point that it bends and deforms so as to stick out on the back side, problems related to the lead wires 7 can be prevented as follows, just as when the lead wires 7 shrink as discussed above.

Specifically, even if deformation of the solar cell module 1B due to bending tugs on the lead wires 7 and places stress on the lead wires 7 bonded with the adhesive agent 8 to the back of the solar cells 3, these lead wires 7 are stretchable because they are formed in a curved shape as mentioned above, and this prevents the lead wires 7 from breaking in the middle, or the solar cells 3 from separating from the glass substrate 2.

With the solar cell module 1A and the solar cell module 1B of the above-mentioned first embodiment, the proximal ends of the lead wires 7 are connected to the end electrodes 6 formed at both ends of a serial connection in a state in which the solar cells 3 are serially connected.

However, what the proximal ends of the lead wires 7 are connected to is not limited to this, and intermediate electrodes that are similar to the end electrodes 6 may instead be provided between the serial connection in a state in which the solar cells 3 have been serially connected, and the proximal ends of the lead wires 7 may be connected to the intermediate electrodes.

### Second Embodiment

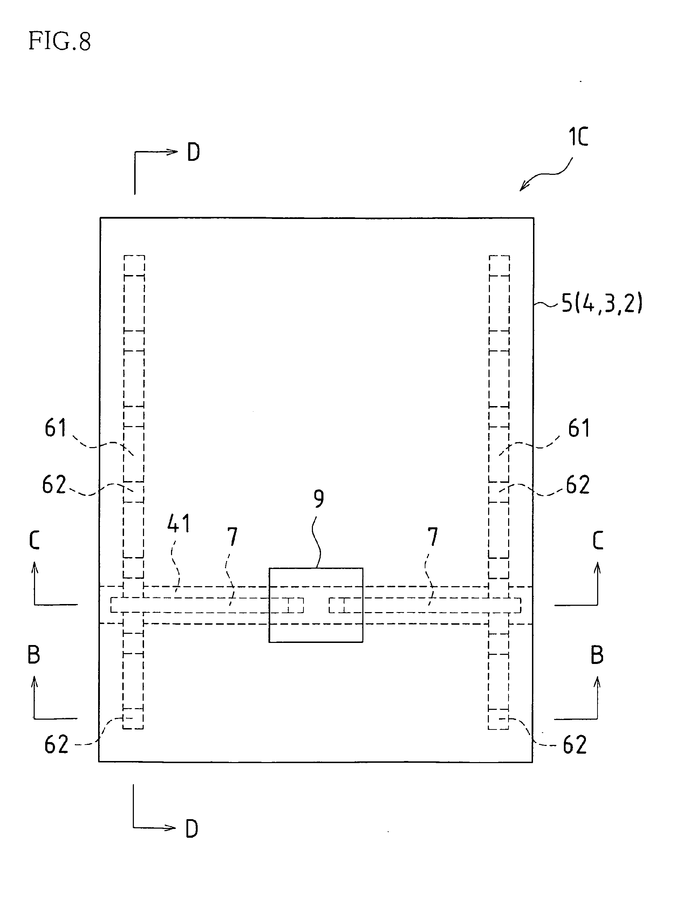

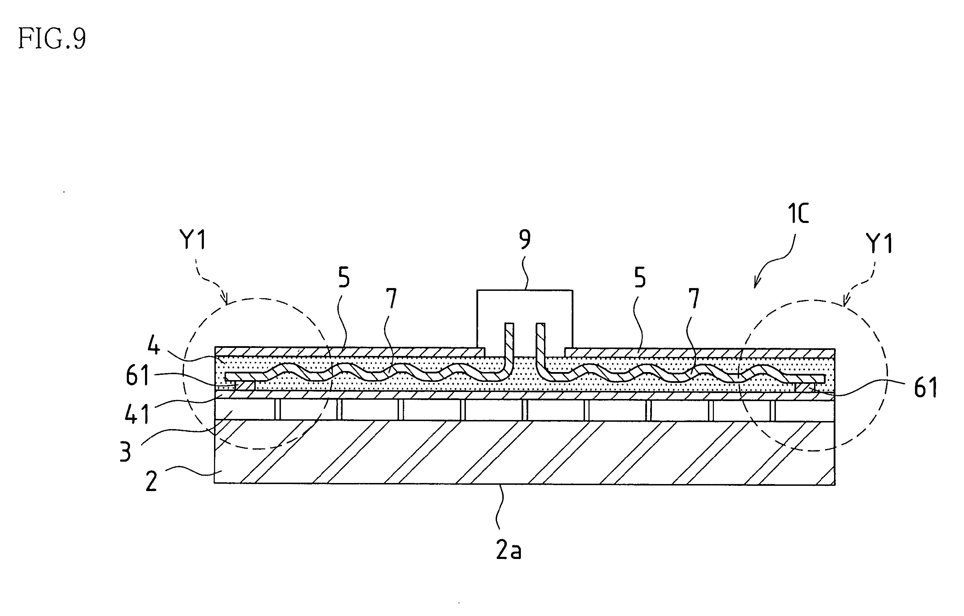

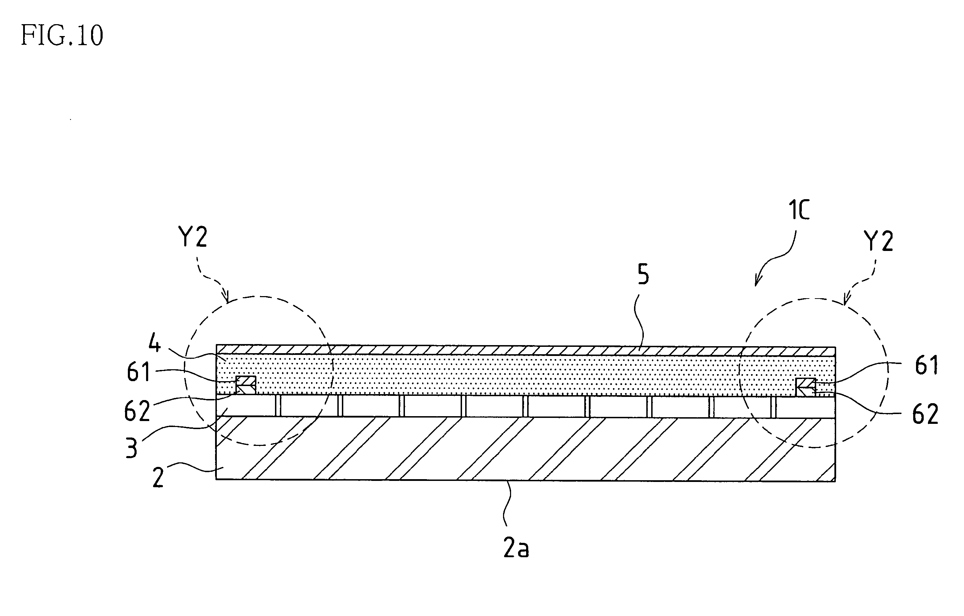

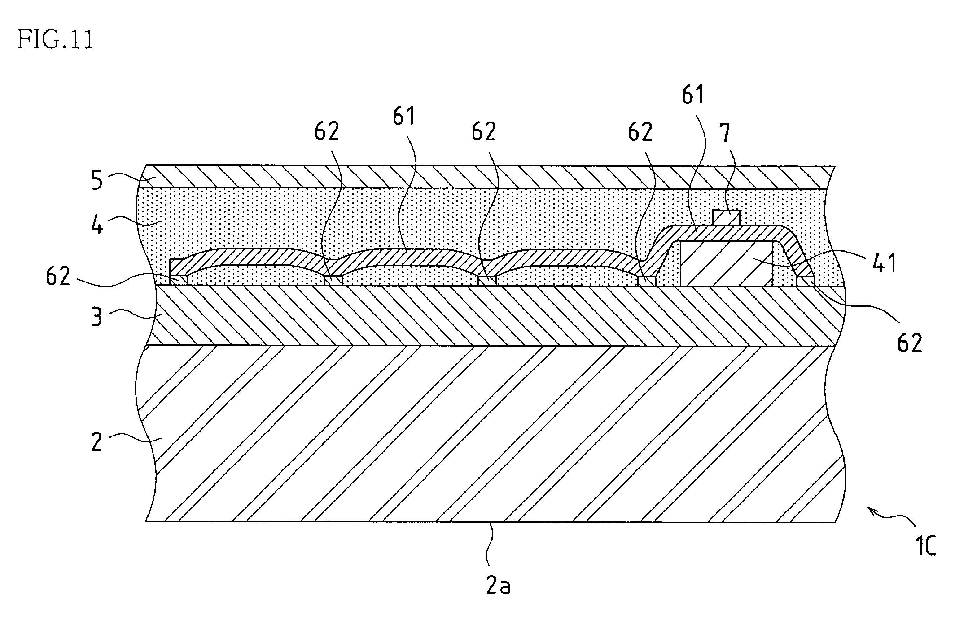

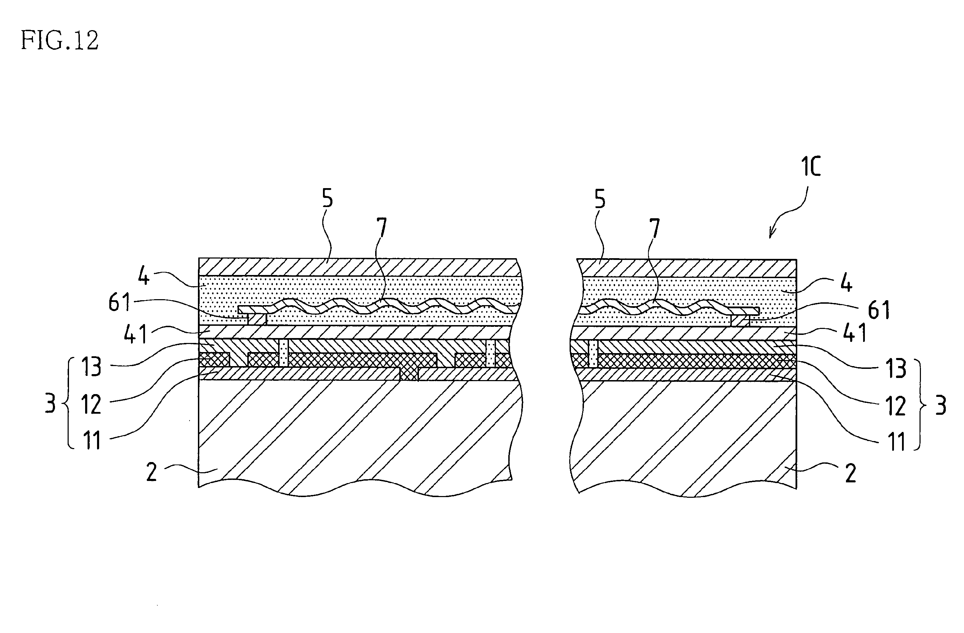

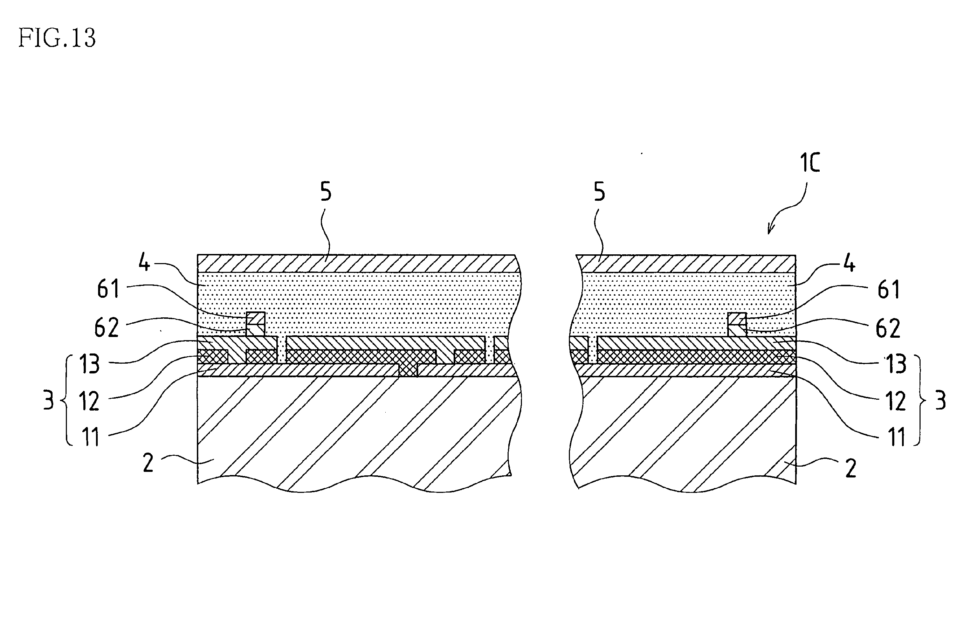

FIG. 8 is a plan view of a solar cell module 1C according to a second embodiment as seen from the back side. FIG. 9 is a cross section along the C-C line in FIG. 8. FIG. 10 is a cross section along the B-B line in FIG. 8. FIG. 11 is a cross section along the D-D line in FIG. 8. FIG. 12 is a detailed enlargement of the Y1 portion in FIG. 9. FIG. 13 is a detailed enlargement of the Y2 portion in FIG. 10.

In FIGS. 8 to 13, the solar cell module 1C of the second embodiment has substantially the same structure as the solar cell module 1A of the first embodiment above. The solar cell module 1C of the second embodiment differs from the solar cell module 1A of the first embodiment above in the following respect.

With the solar cell module 1A, in FIGS. 1 and 2, the end electrodes 6 are formed in the lengthwise direction of the solar cell module 1A on the rear metal layer 13 of the left-end solar cell 3 connected to the transparent conductive film layer 11 of the adjacent solar cell 3 on the right side which is adjacent to the left-end solar cell 3, and on the rear metal layer 13 of the solar cell 3 at the right end.

The proximal ends of lead wires 7, which are made of copper or aluminum foil and curved in the up-and-down direction, for example, are connected one each to these end electrodes 6. These lead wires 7 are drawn out from the end electrodes 6, along the glass substrate 2 through the resin filling layer 4, and toward the center of the cell module 1A.

In contrast, with the solar cell module 1C, the portion corresponding to the portion described above for the solar cell module 1A has the following structure. The portion corresponding to the end electrodes 6 of the solar cell module 1A is made up of end bridge electrodes 61 and end leg electrodes 62, as shown in FIGS. 8 and 11. Of these, the end bridge electrodes 61 correspond to the extraction electrodes discussed above.

With the solar cell module 1C, as shown in FIGS. 8, 10, 11, and 13, a plurality of end leg electrodes 62 are formed, spaced apart, on a line along the lengthwise direction of the solar cell module 1C, on the rear metal layer 13 of the left-end solar cell 3 connected to the transparent conductive film layer 11 of the right-side adjacent solar cell 3 that is adjacent to the left-end solar cell 3, and on the rear metal layer 13 of the right-end solar cell 3. As shown in FIGS. 8 and 11, the end bridge electrodes 61 are formed so as to span the spaces between these end leg electrodes 62.

Furthermore, as shown in FIGS. 8 and 11, a strip of an insulating resin film forming layer 41 is formed between the solar cell 3 and the end bridge electrode 61 at the locations where the lead wires 7 are provided. Specifically, the strip of insulating resin film forming layer 41 is formed as shown in FIG. 11 on the back side of the solar cell 3 at the locations where the lead wires 7 are provided.

The above-mentioned end bridge electrode 61 spans this insulating resin film forming layer 41, and as shown in FIGS. 8, 9, 11, and 12, the proximal ends of the lead wires 7 formed curving in the up-and-down direction are connected to the end bridge electrodes 61 that span the insulating resin film forming layers 41.

As shown in FIG. 8, 9, and 12, the lead wires 7 formed curving in the up-and-down direction and connected at their proximal ends to the end bridge electrodes 61 are drawn out from the end bridge electrodes 61, along the insulating resin film forming layers 41, through the resin filling layer 4, and toward the center of the solar cell module 1C.

These lead wires 7 bend upward at the center of the solar cell module 1C, and their distal ends protrude upward from the resin filling layer 4 and are housed inside the terminal box 9. In the drawings referred to above, the shape inside the terminal box 9 is partially omitted.

The solar cell module 1C of the second embodiment above is the same as the solar cell module 1A of the first embodiment above in that the lead wires 7 are formed curving in the up-and-down direction. Accordingly, this solar cell module 1C has the same operation and effect as the solar cell module 1A of the first embodiment above.

In addition to the above, the solar cell module 1C of the second embodiment above also has the following operation and effect. With the solar cell module 1A of the first embodiment, the proximal ends of the lead wires 7 are connected to the end electrodes 6 formed on the rear metal layer 13 of the solar cells 3. Therefore, any stress exerted on the lead wires 7 is directly exerted on the end electrodes 6.

In contrast, with the solar cell module 1C of the second embodiment above, the proximal ends of the lead wires 7 are connected to the end bridge electrodes 61 that are formed spanning the spaces between the plurality of end leg electrodes 62 formed on the rear metal layer 13 of the solar cells 3 of the solar cell module 1C, as discussed above.

Therefore, with the solar cell module 1C, any stress exerted on the lead wires 7 is not directly exerted on the end leg electrodes 62 connected to the rear metal layer 13, and is instead exerted indirectly via the end bridge electrodes 61 formed so as to span the spaces between the end leg electrodes 62.

Accordingly, with the solar cell module 1C, the following operation and effect are manifested when a difference in the coefficients of thermal expansion between the lead wires 7 and the glass substrate 2 of the solar cell module 1C causes the lead wires 7 to shrink, or when the glass substrate surface 2a of the solar cell module 1C is buffeted by a strong wind to the point that it bends and deforms so that it sticks out on the back side, which places stress on the proximal ends of the lead wires 7 connected to the end electrodes 6.

Specifically, in the above case, the curved shape of the lead wires 7 combines with a structure in which the proximal ends of the lead wires 7 are connected via the end bridge electrodes 61, rather than directly, to the end leg electrodes 62 connected to the rear metal layer 13, to further enhance the effect of preventing breakage at the proximal ends of the lead wires 7, or separation of the end bridge electrodes 61 from the rear metal layer 13 of the solar cell 3 as compared to the solar cell module 1A of the first embodiment. For example, if the lead wires 7 are 2.0 mm wide, 0.08 mm thick, and 870 mm long, there is no stress relieving mechanism such as the undulations in Working Example 1, and the lead wire proximal ends are connected directly to the rear metal layer 13, a tensile force of 60 N or higher will be exerted on the connected parts at low temperature, but if they are connected to the rear metal layer 13 at the two end leg electrodes 62 that are separated from each other by 80 mm via the end bridge electrodes 61, then the force exerted on the connected parts will be only 8 N even though there is no stress relieving mechanism in the lead wires 7.

As to the curved shape of the lead wires 7 in the solar cell module 1C of the second embodiment above, just as with the solar cell module 1A of the first embodiment above, the shape may be undulations that continuously curve in the up-and-down direction, or may be any of the curved shapes, etc., described for the solar cell module 1A in the first embodiment above. This allows the tensile force exerted on the connected parts to be as low as 1 N or less.

As shown in FIG. 9, with the solar cell module 1C of the second embodiment above, the lead wires 7 that are drawn out so as to curve in the up-and-down direction from the end electrodes 6 toward the center of the solar cell module 1C extend through the resin filling layer 4 and are embedded in the resin filling layer 4, but are not bonded on the solar cells 3.

However, the lead wires 7 that are drawn out from the end electrodes 6 toward the center of the solar cell module 1C may be bonded to the insulating resin film forming layers 41 formed on the solar cell 3. This affords the same operation and effect as with the solar cell module 1B of the first embodiment above.

With the solar cell module 1C of the second embodiment above, the proximal ends of the lead wires 7 are connected to the end bridge electrodes 61 formed at both ends of a serial connection in a state in which the solar cells 3 are connected in series.

However, what the proximal ends of the lead wires 7 are connected to is not limited to this. If intermediate leg electrodes and intermediate bridge electrodes that are the same as the end bridge electrodes 61 and the end leg electrodes 62 are provided intermediate of the serial connection in a state in which the solar cells 3 are connected in series, the proximal ends of the lead wires 7 may be connected to these intermediate bridge electrodes.

The present invention can be worked in various configurations without departing from the spirit or main features thereof. Therefore, the above embodiments are in all respects nothing more than mere examples, and should not be interpreted as limiting in nature. The scope of the present invention is as indicated by the claims, and is not restricted whatsoever to the text of this specification. Furthermore, all modifications and variations belonging to a scope equivalent to the claims fall within the scope of the present invention.

This application claims priority right on the basis of Japanese Patent Application No. 2009-185040 filed on August 7, 2009 in Japan, the content of which is incorporated herein by reference. The publications cited in this specification are specifically incorporated by reference in their entirety.

### Description of Reference Numerals

- 1A: Solar Cell Module
- 1B: Solar Cell Module
- 1C: Solar Cell Module
- 2: Glass Substrate
- 2a: Glass Substrate Surface
- 3: Solar Cell
- 4: Resin Filling Layer
- 41: Insulating Resin Film Forming Layer
- 5: Back Sheet Layer
- 6: End Electrode
- 61: End Bridge Electrode
- 62: End Leg Electrode
- 7: Lead Wire
- 8: Adhesive Agent
- 9: Terminal Box
- 10: Cut Location
- 11: Transparent Conductive Film Layer
- 12: Amorphous Semiconductor Layer
- 13: Rear Metal Layer
- 100A: Solar Cell Module
- 100B: Solar Cell Module

## Claims

1. A solar cell module, comprising:
an insulating substrate;
a plurality of solar cells that are formed in rows and disposed in parallel on the insulating substrate, and that are connected in series;
extraction electrodes that are provided intermediate or at both ends of the serial connection; and
lead wires that are connected at their proximal ends to the extraction electrodes, and are drawn out from the extraction electrodes along the insulating substrate,
wherein the lead wires are formed in a curve.

2. The solar cell module according to claim 1,
wherein the lead wires are formed in a curve in an approximate thickness direction of the insulating substrate.

3. The solar cell module according to claim 1,
wherein the lead wires are formed in a curve in a direction approximately parallel to the insulating substrate.

4. A solar cell module, comprising:
an insulating substrate;
a plurality of solar cells that are formed in rows and disposed in parallel on the insulating substrate, and that are connected in series;
extraction electrodes that are provided intermediate or at both ends of the serial connection; and
lead wires that are connected at their proximal ends to the extraction electrodes, and are drawn out from the extraction electrodes along the insulating substrate,
wherein the lead wires are formed in a mesh shape.

5. The solar cell module according to any one of claims 1 to 4,
wherein a resin filling layer is formed over the solar cells, and the lead wires are embedded in the resin filling layer.

6. The solar cell module according to claim 5,
wherein the lead wires are bonded on the solar cells.
